(19) Europäisches Patentamt
European Patent Office
Office européen des brevets

(11) **EP 4 597 024 B1**

(12) **EUROPEAN PATENT SPECIFICATION**

(45) Date of publication and mention
of the grant of the patent:
**29.07.2026 Bulletin 2026/31**

(21) Application number: **25152185.2**

(22) Date of filing: **16.01.2025**

(51) International Patent Classification (IPC):
*F42C 11/00* (2006.01)   *F42D 1/05* (2006.01)
*B60R 21/017* (2006.01)

(52) Cooperative Patent Classification (CPC):
**F42C 11/001; B60R 21/017; B60R 21/0173;
F42D 1/05**

(54) **DEPLOYMENT CIRCUIT FOR A PYROTECHNIC DEVICE, CORRESPONDING INTEGRATED CIRCUIT, VEHICLE AND METHOD**

AUSLÖSESCHALTUNG FÜR EINE PYROTECHNISCHE VORRICHTUNG, ENTSPRECHENDE INTEGRIERTE SCHALTUNG, FAHRZEUG UND VERFAHREN

CIRCUIT DE DÉPLOIEMENT D'UN DISPOSITIF PYROTECHNIQUE, CIRCUIT INTÉGRÉ, VÉHICULE ET PROCÉDÉ CORRESPONDANTS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **01.02.2024 IT 202400002019**

(43) Date of publication of application:
**06.08.2025 Bulletin 2025/32**

(73) Proprietor: **STMicroelectronics International N.V.
1228 Plan-les-Ouates, Geneva (CH)**

(72) Inventors:
• **D'ANGELO, Vittorio
84015 Nocera Superiore (IT)**
• **CANNAVACCIUOLO, Salvatore
80010 Villaricca (NA) (IT)**
• **GIORDANO, Antonio
20148 Milano (IT)**
• **PEDONE, Leonardo
62012 Civitanova Marche (IT)**

(74) Representative: **Buzzi, Notaro & Antonielli d'Oulx
S.p.A.
Corso Vittorio Emanuele II, 6
10123 Torino (IT)**

(56) References cited:
**US-A1- 2017 349 126   US-A1- 2019 302 162**

**Description**

Technical field

The present disclosure relates to circuits for deploying an electrically activated pyrotechnic device, such as a squib, a pyro-fuse or a pyro-actuator, and corresponding methods.

Technological background

Electrically activated pyrotechnic devices serve as indispensable components for delivering substantial amounts of energy within extremely brief deployment windows and, for this reason, are widespread in safety applications. Notably, this category includes squibs utilized for airbag activation, pyro-fuses designed to swiftly disconnect electrical connections, such as, for example, a connection of an electric vehicle (EV) battery in the event of a short to ground fault, and pyro-actuators.

In the context of safety applications, various solutions have been proposed for monitoring the correct connection of the pyrotechnic device to the deployment circuit. For example, such solutions are disclosed in United States Patent Application Publications nos. US 2018/0029554 A1 and US 2019/0302162 A1. Substantially, such solutions are based on the fact that the pyrotechnic device usually has a resistance value being in a given tolerance range. Accordingly, by determining whether the resistance value between the terminals connected to the pyrotechnic device are between a lower threshold value and an upper threshold value, the deployment circuit may determine whether the pyrotechnic device is correctly connected to the deployment circuit.

Conversely, the actual deployment of the pyrotechnic device is usually detected via auxiliary sensors. For example, such a solution is disclosed by United States Patent Publication no. US 10,029,640 B2 or JP 1002/144994 A in the context of a deployment detection of an airbag.

Moreover, document US 2017/349126 A1 discloses a deployment circuit according to the preamble of Claim 1, in which the deployment is detected by monitoring a voltage at the pyrotechnic device.

Object and summary

Given the mission-critical nature of numerous applications in which pyrotechnic devices are employed, a pressing need exists for innovative solutions that enable real-time monitoring of deployment outcomes.

According to one or more embodiments that object may be achieved by means of a deployment circuit for a pyrotechnic device. Embodiments moreover concern a related integrated circuit, vehicle and method.

The invention is defined by the appended independent claims. The claims are an integral part of the technical teaching of the disclosure provided herein.

As mentioned before, various embodiments of the present disclosure relate to a deployment circuit, e.g., integrated in an integrated circuit, for a pyrotechnic device, such as a squib, a pyro-fuse or a pyro-actuator, e.g., of a vehicle.

In various embodiments the deployment circuit comprises a first terminal and a second terminal configured to be connected to the pyrotechnic device, a driver circuit, a monitoring circuit and a control circuit.

In various embodiments, the driver circuit is configured to energize the pyrotechnic device by selectively applying a voltage or current to the first terminal and second terminal as a function of at least one control signal. For example, in various embodiments, the driver circuit comprises at least one electronic switch configured to selectively connect the first terminal and the second terminal to a supply voltage as a function of the at least one control signal. Additionally, the driver circuit may comprise a current limiter connected in series with the first terminal and the second terminal in order to limit the current provided to the first terminal and second terminal to a maximum value. Alternatively, the driver circuit may be configured as a regulated current source, which directly provides a requested current. In various embodiments, the maximum value or the requested current is settable via the at least one control signal.

In various embodiments, the monitoring circuit is configured to measure a voltage across the first terminal and the second terminal, process the measured voltage, and determine whether the processed voltage is greater than a threshold. In response to determining that the processed voltage is greater than the threshold, the monitoring circuit asserts a comparison signal.

Specifically, the processed signal should indicate whether the pyrotechnic device deployed.

For example, in various embodiments, the processed signal is indicative of the resistance value of the pyrotechnic device. For example, for this purpose, the monitoring circuit may also measure the current provided via the first terminal and second terminal, and generate the processed voltage by calculating the ratio between the measured voltage and the measured current, whereby the processed voltage is indicative of the resistance of the pyrotechnic device.

However, instead of directly measuring the resistance value of the pyrotechnic device, the monitoring circuit may also generate other processed signals which are still indicative of the resistance value of the pyrotechnic device or an increase of the resistance value of the pyrotechnic device. For example and outside of the scope of the invention, for this purpose the measurement circuit may generate the processed voltage by filtering the measured voltage with a low-pass filter or a band-pass filter.

In accordance with the invention, e.g., when using a deployment cycle having a fixed duration, the monitoring circuit generates the processed voltage by calculating the integral of the measured voltage. Alternatively, the monitoring circuit may generate the processed voltage by calculating the integral of the square of the measured voltage.

In various embodiments, the control circuit is configured to receive a fire request signal and the comparison signal. In response to the fire request signal, the control circuit generates the at least one control signal in order to energize the pyrotechnic device via the driver circuit. For example, for this purpose, in response to the fire request signal, the control circuit may start a timer, and determine whether the timer reaches a time threshold. Accordingly, in response to determining that the timer reaches the time threshold, the control circuit may stop the energization of the pyrotechnic device.

Moreover, in various embodiments, the control circuit determines whether the comparison signal is asserted. For example, in various embodiments, the control circuit is configured to determine whether the comparison signal is asserted, in response to determining that the timer reaches the time threshold.

Alternatively, in response to the fire request signal, the control circuit may set the maximum value of the current limiter or the requested current to a first value used to energize the pyrotechnic device. Next, in response to determining that the timer reaches the time threshold, the control circuit may set the maximum value of the current limiter or the requested current to a second value, wherein the second value is smaller than the first value, thereby using a lower measurement current. Accordingly, in this case, once having set the maximum value of the current limiter to the second value, the control circuit may determine whether the comparison signal is asserted.

Accordingly, in various embodiments, when asserted, the comparison signal indices that the pyrotechnic device deployed. Accordingly, in various embodiments, in response to determining that the comparison signal is de-asserted, the control circuit may energize again the pyrotechnic device. In various embodiments, the control circuit may also wait for a predetermined amount of time before energizing again the pyrotechnic device.

For example, in order to energize again the pyrotechnic device, the control circuit may generate again the at least one control signal in order to energize the pyrotechnic device via the driver circuit.

The deployment circuit comprises a further driver circuit configured to energize the pyrotechnic device by selectively applying a voltage or current to the first terminal and second terminal as a function of at least one further control signal. Accordingly, in this case, the control circuit may generate the at least one further control signal in order to energize the pyrotechnic device via the further driver circuit. In general, the control circuit may also be split in two parts, wherein a first control circuit manages the operation of the driver circuit and the monitoring circuit, and a second control circuit manages the operation of the further driver circuit. For example, in this case, in response to determining that the comparison signal is de-asserted, the first control circuit may provide a further fire request signal to the second control circuit. Accordingly, in various embodiments, the first and the second control circuit may have substantially the same structure, wherein the second control circuit and the further driver circuit operate as a backup deployment circuit.

Brief description of the drawings

Embodiments of the present disclosure will now be described with reference to the annexed drawings, which are provided purely by way of non-limiting example and in which:

- Figure 1 shows a first embodiment of circuit for deploying a pyrotechnic device according to the present disclosure;
- Figure 2 shows a second embodiment of circuit for deploying a pyrotechnic device according to the present disclosure;
- Figure 3 shows a flowchart representing an embodiment of a method for deploying a pyrotechnic device;
- Figure 4 shows exemplary waveforms when using the method of Figure 3 during a first deployment cycle;
- Figure 5 shows exemplary waveforms when using the method of Figure 3 during a second deployment cycle;
- Figure 6 shows an exemplary embodiment of a system comprising two daisy-chained deployment circuits according to the present disclosure.

Detailed description

In the following description, numerous specific details are given to provide a thorough understanding of embodiments. The embodiments can be practiced without one or several specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for convenience only and do not interpret the scope or meaning of the embodiments.

As mentioned before, various embodiments of the present disclosure provide solutions for deploying a pyrotechnic device.

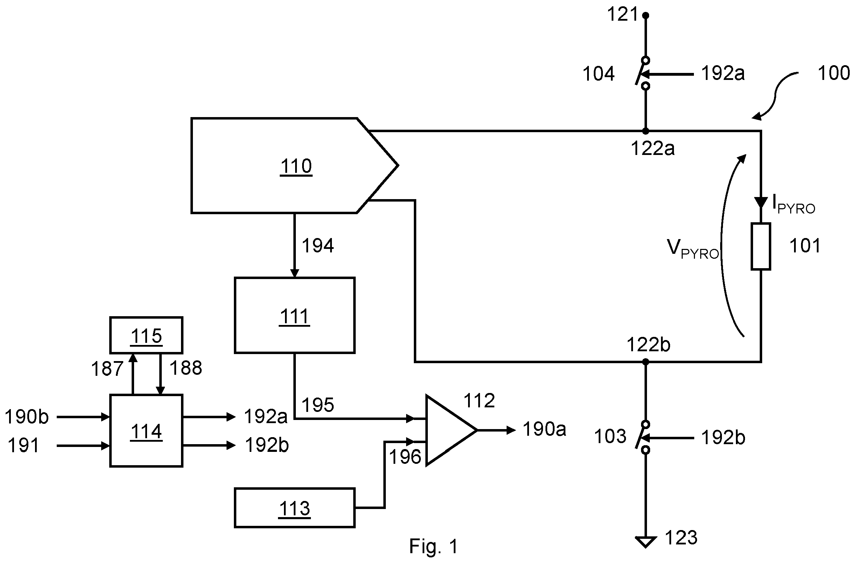

Figure 1 shows an embodiment of a deployment circuit 100 according to the present disclosure.

In the embodiment considered, the deployment circuit 100 comprises a first terminal 122a and a second terminal 122b configured to be connected to an electrically activated pyrotechnic device 101. For example, in various embodiments, the pyrotechnic device 101 may be an airbag squib, a seat belt pretensioner initiator, a pyro-switch or a pyro-fuse.

In the embodiments considered, the deployment circuit 100 comprises moreover a driver circuit configured to selectively energize the pyrotechnic device 101. Typically, the driver circuit is configured to apply a given voltage $V_{PYRO}$ to the terminals 122a and 122b or control a current $I_{PYRO}$ provided via the terminals 122a and 122b. In fact, from an electrical point of view, a pyrotechnic device 101 to be fired represents mainly a resistive load.

For example, in Figure 1, the driver circuit is configured to selectively connect the terminals 122a and 122b to a supply voltage $V_{IN}$. For this purpose, the driver circuit may comprise a first terminal 121 and a second terminal 123, e.g., representing a ground GND, configured to receive the supply voltage $V_{IN}$. For example, the voltage $V_{IN}$ may be provided by a battery, e.g., of a vehicle comprising the pyrotechnic device 101, e.g., associated with respective airbags of the vehicle. Alternatively, the supply voltage $V_{IN}$ may be provided by one or more capacitances (not shown in Figure 1). For example, such capacitance(s) may be charged by an additional electronic converter, such as a step-up or step-down converter.

Specifically, in the embodiment shown in Figure 1, the driver circuit comprises a first electronic switch 104 configured to connect the terminal 122a to the terminal 121 as a function of a first drive signal 192a and/or a second electronic switch 103 configured to connect the terminal 122b to the terminal 123 as a function of a second drive signal 192b. For example, the switches 103 and 104 may be Field-Effect Transistors (FET), such as Metal-Oxide-Semiconductor Field-Effect Transistors (MOSFET). For example, each switch 103 and 104 may be a normally open switch, such as a depletion mode MOSFET, which is closed in response to the reception of an asserted driving signal (192b or 192a).

Accordingly, when the terminals 122a and 122b are connected to the supply voltage, e.g., when the electronic switches 103 and 104 are closed, the voltage $V_{IN}$ is also applied to the pyrotechnic device 101 (neglecting possible parasitic resistances, e.g., of cables), i.e., the voltage $V_{PYRO}$ at the pyrotechnic device 101 correspond to the voltage $V_{IN}$, whereby a current $I_{PYRO}$ flows through the pyrotechnic device 101.

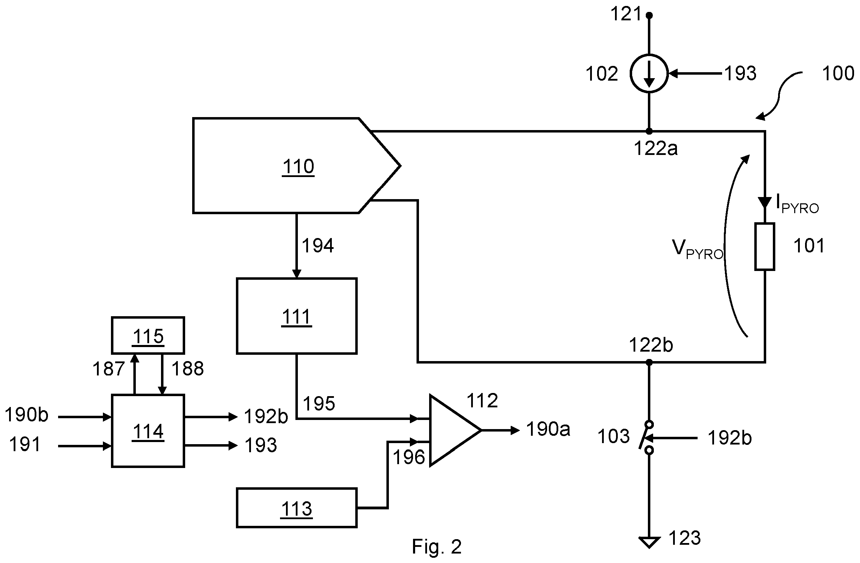

Conversely, in Figure 2, the driver circuit is configured to selectively apply a current to the terminals 122a and 122b. For example, in the embodiment considered, the driver circuit comprises a current source or current limiter 102 configured to set or limit, respectively, the current provided via the terminals 122a and 122b.

Specifically, in the embodiment shown in Figure 2, the driver circuit comprises a current source or current limiter 102 connected between the terminal 122a and the terminal 121. In various embodiments, the current source or current limiter 102 may be configured to set the requested current or the maximum current, respectively, as a function of a reference signal 193. For example, the circuit 102 may be implemented with a field effect transistor (FET). For example, this FET may correspond to the output stage of a current mirror.

In various embodiments, the driver circuit may also comprise the first electronic switch 104 and/or the second electronic switch 103 shown in Figure 1. For example, in Figure 2, the driver circuit comprises the electronic switch 103 configured to connect the terminal 122b to the terminal 123 as a function of a second drive signal 192b. Accordingly, in the embodiment considered, the driver circuit is configured to regulate or at least limit the current $I_{PYRO}$ flowing through the pyrotechnic device 101.

For example, a current source 102 may be implemented by measuring the current $I_{PYRO}$, such as the current flowing through the electronic switch 104 and/or 103 (see Figure 1), wherein the driver circuit comprises a closed loop control circuit configured to regulate the measured current to a requested value by selectively connecting the terminals 122a and 122b to the voltage $V_{IN}$ or disconnecting the terminals 122a and 122b from the voltage $V_{IN}$, e.g., via the electronic switches 104 and 103.

Conversely, the driver circuit may implement a current limiter 102 by connecting the terminals 122a and 122b to the voltage $V_{IN}$ when the measured current $I_{PYRO}$ is smaller than the maximum request value, and disconnecting the terminals 122a and 122b from the voltage $V_{IN}$ when the measured current $I_{PYRO}$ is greater than the maximum request value. In various embodiments, the comparison may also comprise a hysteresis, i.e., the driver circuit may be configured to disconnect the terminals 122a and 122b from the voltage $V_{IN}$ when the measured current $I_{PYRO}$ is greater than the maximum request value, and connect the terminals 122a and 122b to the voltage $V_{IN}$ when the measured current $I_{PYRO}$ is smaller than a minimum request value.

Accordingly, in various embodiments, the deployment circuit 100 comprises also a control circuit 114 configured to generate one or more of the signals 192a, 192b and 193 as a function of a fire or deployment request signal 191. In various embodiments, the signal 191 is generated by an external deployment control circuit.

For example, in the embodiment shown in Figure 1, in response to detecting that the deployment request signal 191 indicates a request to fire, e.g., when the signal 191 is asserted, the control circuit 114 asserts the (high-side) driving signal 192a and the (low-side) driving signal 192b.

Conversely, in the embodiment shown in Figure 2, in response to detecting that the deployment request signal 191 indicates a request to fire, e.g., when the signal 191 is asserted, the control circuit 114 asserts the (low-side) driving signal 192b. In case the current source or limiter 102 is configurable, the control circuit 114 may also generate the signal 193 in order to set the current $I_{PYRO}$ to a given requested value or limit the current $I_{PYRO}$ to a given maximum value. Alternatively, the control circuit 114 may be configured to measure the current $I_{PYRO}$, and drive the electronic switches 103 and/or 104 as a function of the measured current, e.g., by implementing a closed loop control of the current $I_{PYRO}$, or a comparison with one or more threshold values, such as a maximum and minimum current.

In various embodiments, the deployment circuit 100 is configured to monitor and analyze the voltage at the terminals 122a and 122b.

In various embodiments, the deployment circuit 100 comprises for this purpose an analog-to-digital converter (ADC) 110, connected to the terminals 122a and 122b of the pyrotechnic device 101, i.e., the ADC 110 is configured to receive the voltage at the terminals 122a and 122b, i.e., the voltage $V_{PYRO}$ across the pyrotechnic device 101, and generate a digital signal 194 being indicative of the voltage $V_{PYRO}$. For example, the ADC 110 may be a sigma-delta converter, however alternative embodiments employing different ADC architectures, such as a flash ADC or a successive-approximation ADC, are possible.

In the embodiment considered, the digital signal 194 produced as output by the analog to digital converter 110 is received by a processing circuit 111 being configured to process the digital sample 194 of the voltage $V_{PYRO}$. In general, instead of using a digital processing, the same operations may also be implemented via an analog processing circuit, i.e., the ADC 110 is purely optional. Accordingly, in general, the processing circuit 111 may be implemented with any analog or digital processing circuit, or a combination thereof.

In various embodiments, the processing circuit 111 is configured to analyze the analog value of the voltage $V_{PYRO}$ or the digital sample provided by the ADC 110, indicated in the following for simplicity just as signal 194, and generates a processed signal 195. Accordingly, also the processed signal 195 may be and analog or digital signal, respectively.

In various embodiments, a comparator 112 is configured to generate a deployment status signal 190a by comparing the processed signal 195 with a threshold 196. Specifically, in various embodiments, in response to determining that the processed signal 195 is greater than the threshold 196, the comparator 112 is configured to assert the deployment status signal 190a, e.g., set the signal 190a to high.

Accordingly, based on whether the processed signal 195 is analog or digital, also the comparator may be implemented with an analog or digital comparator, respectively. For example, in various embodiments, the circuit 100 comprises the ADC 110, a digital processing circuit 111 and a digital comparator 112, wherein the signal 113 is a digital threshold value 196, e.g., provided by a register 113. For example, in various embodiments, the processing circuit 111 and the comparator 112 may be implemented with same digital processing circuit, e.g., a microprocessor programmed via software instructions. For example, in this case, the ADC 110 and the microprocessor 111 and 112 may be implemented with a microcontroller. In various embodiments, also the control circuit 114 may me a digital control circuit and, e.g., implemented via software instructions executed by the microprocessor.

As mentioned before, in various embodiments, the processing circuit 111 is configured to process the signal 194 and generate a processed signal 195. For example, in various embodiments, the signal 195 may be indicative of the specific energy for unit resistance, $i^2t$, supplied to the pyrotechnic device 101 and may be, for instance, a resistance, a voltage or a specific energy per unit resistance. Further details regarding the fashion according to which the acquired voltage 194 is processed into processed data 195 will be provided in the following.

Accordingly, in various embodiments, the deployment circuit 100 comprises a comparator circuit 112 configured to compare the signal 195 to a (e.g., programmable) deploy threshold 196, and produce as output a fire good signal 190a if the signal 195 is greater than (or equal to) the programmable deploy threshold 196. Further details regarding the physical quantities represented by the processed signal 195 will be provided in the following.

In various embodiments, the control circuit 114 is coupled to a timer circuit 115. In various embodiments, also the time circuit 115 may be implement via software instruction executed by a microprocessor implementing the control circuit 114 and/or the processing circuit 111.

Specifically, in various embodiments, in response to receiving a request to fire signal 191, the control circuit 114 resets the timer circuit 115 i.e., instructs the timer circuit 115 to reset its content and restart the time counting from zero, by sending a reset signal 187. The accumulated time may be stored in a register provided within the timer circuit 115 and is accessible by the control circuit. The control circuit 114 is further configured to repeatedly compare, during a deployment operation, the ongoing time 188 with a time threshold $t_{TIMEOUT}$ indicating a maximum time that a deployment operation can take. In response to determining that the time 188 exceeds the time threshold $t_{TIMEOUT}$, the control circuit 114 interrupts the deployment of the pyrotechnic device. Accordingly, in various embodiments, the control circuit 114 is configured to, in response to a request to fire signal 191, drive the pyrotechnic device 101 for a given maximum time.

Similarly, as mentioned before, in the embodiment shown in Figure 2, the driver circuit is configured to selectively apply a current to the terminals 122a and 122b. For example, in the embodiment considered, the driver circuit comprises a current source or current limiter 102 configured to set or limit, respectively, the current provided via the terminals the terminals 122a and 122b. In various embodiments, the current source or current limiter 102 may be configured to set the requested current or the maximum current, respectively, as a function of a reference signal 193.

Moreover, the driver circuit may comprise a first electronic switch 104 configured to connect the terminal 122a to the terminal 121 as a function of a first drive signal 192a and/or a second electronic switch 103 configured to connect the terminal 122b to the terminal 123 as a function of a second drive signal 192b.

Accordingly, in the embodiment shown in Figure 2, the deployment circuit 100 comprises also a control circuit 114 configured to generate one or more of the signals 192a, 192b and 193 as a function of a fire or deployment request signal 191. For example, also Figure 2 shows the additional timer circuit 115, which may be used to drive the pyrotechnic device 101 only for a given maximum time.

Accordingly, also in this embodiment, the deployment circuit 100 may monitor and analyze the voltage $V_{PYRO}$ at the terminals 122a and 122b. For example, in Figure 2 are shown again the optional ADC 110, the processing circuit 111, the comparator 112 and the threshold signal generator 113.

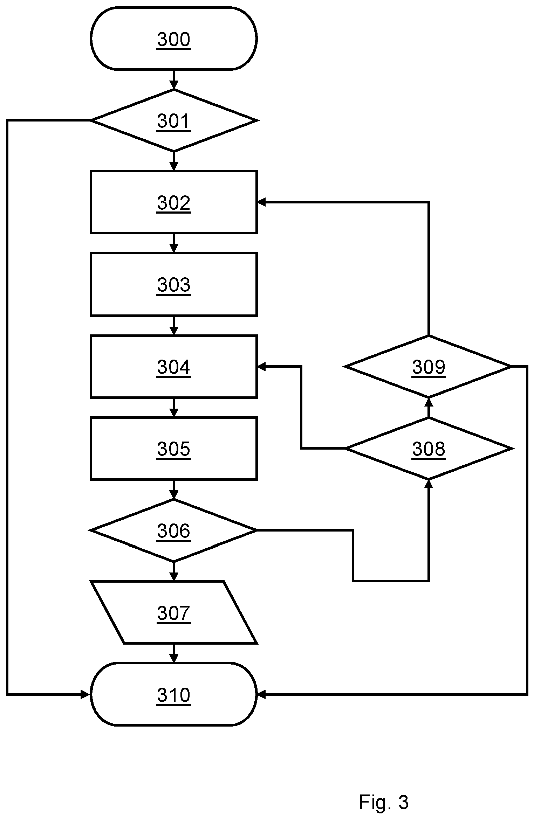

With respect to Figure 3 will now be described a possible embodiment of the operation of the deployment circuits 100 of Figures 1 and 2.

Specifically, Figure 3 shows a start step 300, which is started when the deployment circuit 100, e.g., the control circuit 114, determines that the request to fire signal 191 is asserted.

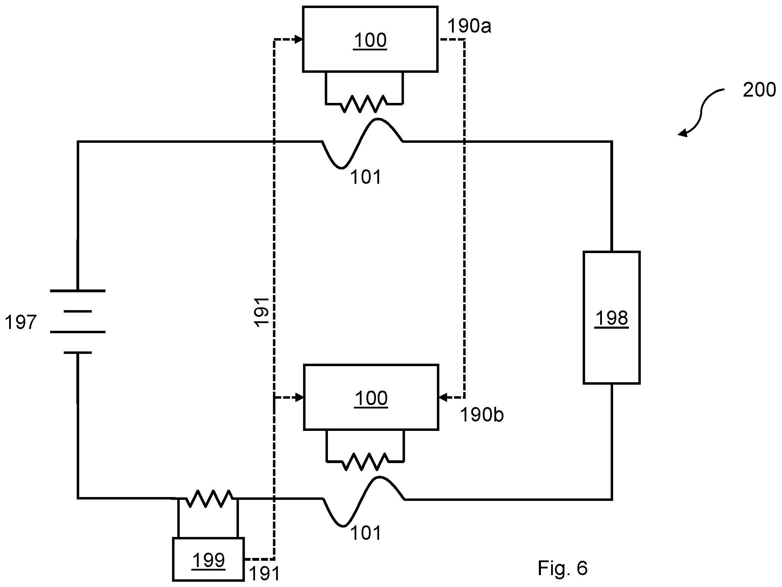

As shown in Figures 1 and 2, the control circuit 114 may also receive an optional fire inhibit signal 190b. For example, such a fire inhibit signal 190b permits to implement a daisy chaining of two or more instances of pyrotechnic device deployment circuits 100, in order to allow configurations with redundant deployment circuits 100, i.e., the fire inhibit signal 190b may be received from another instance of a deployment circuit 100, as illustrated in Figure 6. In such a way, it is possible to attempt the deployment with a primary/first deployment circuit 100a and, if the first deployment fails, to try a second deployment attempt by means of a backup/second deployment circuit 100b. Conversely, if the first deployment attempt is successful, the backup deployment circuit 100b does not fire, as the fire inhibit signal 190b received from the primary deployment circuit 100a is asserted. Further details concerning such configuration are provided in the following.

This is also shown in Figure 3, wherein the deployment circuit 100, e.g., the control circuit 114, is configured to verify in a step 301 whether the fire inhibit signal 190b is asserted or de-asserted.

Specifically, in response to determining that the fire inhibit signal 190b is de-asserted (output "Y" of the verification step 301), the deployment circuit 100, e.g., the control circuit 114, may proceed to a step 302 for starting a deployment cycle. Conversely, in response to determining that the fire inhibit signal 190b is asserted (output "N" of the verification step 301), the deployment circuit 100, e.g., the control circuit 114, may stop the deployment request at a stop step 310, whereby the method terminates.

Accordingly, in case the fire inhibit signal 190b and the respective verification step 301 is omitted, the method may directly proceed to the step 302.

Specifically, in various embodiments, the deployment circuit 100, e.g., the control circuit 114, is configured to drive the driver circuit in order to energize the pyrotechnic device 101, thereby starting a deployment cycle. In accordance with various embodiments, the pyrotechnic device 101 may be energized either by applying a deployment voltage $V_{PYRO}$ to the terminals 122a and 122b, as performed in the exemplary embodiment illustrated in Figure 1, or by providing via the terminals 122a and 122b a deployment current $I_{PYRO}$, as performed in the exemplary embodiment illustrated in Figure 2.

Accordingly, in various embodiments, the deployment circuit 100, e.g., the control circuit 114, may generate one or more of the driving signals 192a and/or 192b for the switches 104 and 103, and/or the reference signal 193 for the current source or current limiter 102.

In various embodiments, such step 302 may be performed after a predetermined time delay $t_{DELAY}$, which is to be counted by means of the timer circuit 115. In particular, configurations such as the system illustrated in Figure 6 may require a non-null time delay $t_{DELAY}$ during the energization of the pyrotechnic device using a backup deployment circuit 100b. This time delay inherently allows a system, such as the one illustrated, to perform the first deployment attempt using the primary deployment circuit 100a as soon as a request to fire 191 is received and, in case of failure of the first deployment attempt, to perform the second deployment attempt using the backup deployment circuit 100b after the time delay $t_{DELAY}$ has elapsed. As specified in the foregoing, the backup driver 100b stops the execution of the deployment routine if it receives a fire inhibit signal 190b from the corresponding daisy-chained primary driver 100a, indicating that such primary driver has successfully deployed the pyrotechnic device 101 and thus a second deployment attempt is no longer required.

As mentioned before, in various embodiments the deployment circuit 100 limits the time of a deployment cycle to a given maximum time. For example, in various embodiments, the deployment circuit 100, e.g., the control circuit 114, starts in a step 303 the timer circuit 115, e.g., by programming a given initial value to the time circuit 115 and enabling the timer circuit 115. In general, the timer circuit 115 may be started immediately before or after, or in parallel with the step 302.

In a following step 304, the deployment circuit 100, e.g., the processing circuit 111, obtains the signal 194, i.e., the voltage $V_{PYRO}$ across the pyrotechnic device 101 or the respective digital sample provided by the ADC 110.

In a following step 305, the deployment circuit 100, e.g., the processing circuit 111, processed the voltage measurement 194 in order to generate a processed signal 195. In general, by processing the voltage $V_{PYRO}$, the signal 195 may represent different physical quantities.

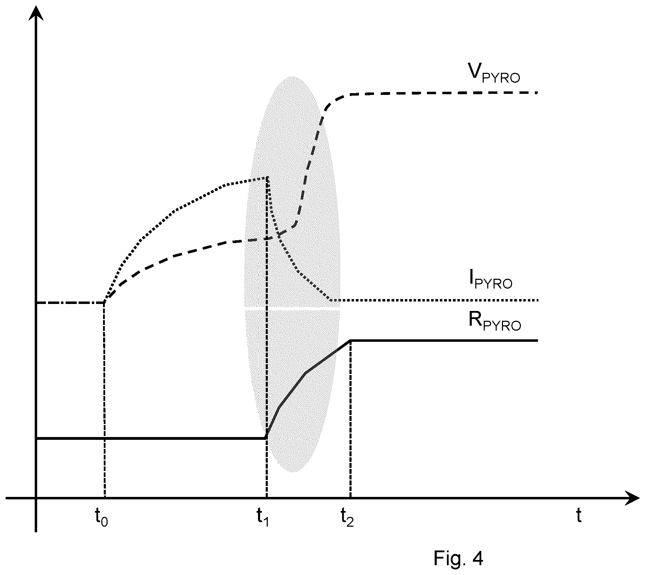

In this respect Figure 4 shows the evolution in time of a current $I_{PYRO}$, a voltage $V_{PYRO}$ and a resistance $R_{PYRO}$ of a pyrotechnic device 101 during a deployment cycle Starting at an instant $t_0$ and ending at an instant $t_2$. For example, as described before, the deployment cycle may be started at the step 302 (instant $t_0$) and may end when the timer circuit 115 reaches a given maximum time (instant $t_2$).

As described before, during the deployment cycle the driving circuit provides via the terminals 122a and 122b a voltage $V_{PYRO}$ and a current $I_{PYRO}$ to the pyrotechnic device 101, which is thus biased.

Specifically, due to parasitic inductances and/or capacitances, the voltage and current provided to the pyrotechnic device 101 usually does not increase with a step form, but rather increases gradually as shown in Figure 4. Moreover, in the embodiment shown in Figure 2, the current $I_{PYRO}$ may be limited to a given maximum value.

In this respect, as described in the foregoing, the pyrotechnic device 101 essentially represents a resistive load, whereby the voltage $V_{PYRO}$ and the current $I_{PYRO}$ are related based on the Ohm's law, i.e., $V_{PYRO} = I_{PYRO} \cdot R_{PYRO}$, where $R_{PYRO}$ corresponds to the resistance of the pyrotechnic device 101.

Specifically, during a deployment cycle, the resistance $R_{PYRO}$ remains initially substantially constant, typical of a non-deployed pyrotechnic device. During this time period the chemical reaction causing the firing of the pyrotechnic device is not triggered yet, indicating that there are no changes in the structure and composition of the pyrotechnic device initiator while the deployment current $I_{PYRO}$ flows through it.

Successively, at a time instant $t_1$, the pyrotechnic device 101 starts to fire. Specifically, the inventors have observed that the firing causing a sudden increase of the resistance $R_{PYRO}$. In turn, this increase of the resistance $R_{PYRO}$ results in a decrease of the deployment current $I_{PYRO}$ and an increase of the voltage $V_{PYRO}$.

Finally, at a time instant $t_2$, the firing of the pyrotechnic device 101 is completed. Consequently, the deployment current $I_{PYRO}$ stops to decrease and the resistance $R_{PYRO}$ settles to a higher value, typical of a successfully deployed pyrotechnic device. Accordingly, the voltage $V_{PYRO}$ increases to a higher value being closer to the supply voltage. Subsequently, the pyrotechnic device deployment circuit 100 detects a successful deployment of the pyrotechnic device and outputs an asserted fire good signal 190a.

Accordingly, the inventors have observed that a correct deployment may be detected by determining an increase of the resistance $R_{PYRO}$.

Specifically, in order to measure the resistance $R_{PYRO}$, the deployment circuit 100 may be configured to provide via the terminals 122a and 122b a (small) measurement current $I_{MEAS}$ and evaluate the value of the signal 194, e.g., via the processing circuit 111 and the comparator. In fact, when the pyrotechnic device 101 is in an undeployed condition, the resistance $R_{PYRO}$ should have a first value $R_{PYRO1}$. Specifically, this first value $R_{PYRO1}$ should be within a given predetermined range. For example, this behavior may be used to determine periodically, whether the pyrotechnic device 101 is connected correctly to the terminals 122a and 122b, i.e., in the absence of a fire request, the deployment circuit 100 may be configured to periodically:

- apply via the driving circuit a measurement current $I_{MEAS}$ to the terminals 122a and 122b;
- monitor via the processing circuit 112 the voltage $V_{PYRO}$ and determine a signal 195 being indicative of the resistance $R_{PYRO}$; and
- determine via the comparator 112 whether the signal 195 is between a lower and an upper threshold.

For example, in this case, in response to determining that the signal 195 is not within the threshold, the deployment circuit 100 may signal a malfunction of the pyrotechnic device 101.

Accordingly, similarly, once having completed a deployment cycle, the deployment circuit 100 may be configured to perform a new measurement of the resistance $R_{PYRO}$ via the measurement current $I_{MEAS}$, and determine whether the signal 195 is greater than the threshold 196. Specifically, in this case, the pyrotechnic device 101 has been deployed correctly when the signal 195 is greater than the threshold 196.

However, the inventors have also observed, that the (higher) deployment current $I_{PYRO}$ during a deployment cycle itself may be used to determine an increase of the resistance $R_{PYRO}$. In this respect, as shown in Figure 4, usually the current $I_{PYRO}$ is not constant during a deployment cycle. However, the inventors have observed that the voltage $V_{PYRO}$ exhibits a significant increase once the pyrotechnic device 101 deploys at the instant $t_2$. Accordingly, in various embodiments, the deployment circuit 100 is configured to analyze the voltage $V_{PYRO}$ during the deployment cycle, i.e., simultaneously to the deployment of the pyrotechnic device 101, and optionally measure and take into account also the current $I_{PYRO}$.

Specifically, in a first embodiment, the deployment circuit 100, e.g., the processing circuit 111 and the comparator 112, is configured to detect an increase of the voltage $V_{PYRO}$, i.e., the signal 195 corresponds to the signal 194 indicative of (and preferably proportional to) the voltage $V_{PYRO}$.

Specifically, in an example not covered by the invention, the deployment circuit 100, e.g., the processing circuit 111, is configured to generate in the step 305 the signal 195 by filtering the signal 194, thereby generating a signal 195 being indicative of a filtered voltage $V_{PYRO'}$. Specifically, in various embodiments, the processing circuit 111 implements a low-pass or a band-bass filter. For example, this permits to avoid glitches and other undesirable effects caused by a transient spike or, more in general, electrical noise that could affect the voltage measurement. For example, in various embodiments, a digital processing circuit 111 may be configured as a digital low-pass filter, such as a finite impulse response (FIR) or infinite impulse response (IIR) filter, configured to receive the digital voltage measurement 194 and return a filtered voltage measurement value 195. For example, the suppression of disturbances affecting the voltage measurement may be performed by means of average filter or a moving average. In various embodiments, the filtering operation is started at the instant $t_0$.

Instead of calculating explicitly an average value, in a third embodiment, the processing circuit 111 is configured to generate a signal 195 corresponding to the integral of the signal 194.

In a fourth embodiment, the processing circuit 111 is configured to generate a signal 195 corresponding to the integral of the square of the signal 194. Hence, in this embodiment, the processing circuit 111 produces as output processed data 195 containing a value

$$E_{PYRO} = \int_{0.}^{t} V_{PYRO}^2 \, dt \cdot$$

In an example not covered by the invention, the processing circuit 111 may also measure the current $I_{PYRO}$, e.g., by monitoring via the ADC 110 a voltage drop at a shunt resistor connected in series with the pyrotechnic device 101, or directly a voltage drop at the electronic switch 103 or 104. In this case, the processing circuit 111 may be configured to determine a signal 195 being indicative of (and preferably proportional to) the resistance $R_{PYRO}$ based on the Ohm's law, i.e., $R_{PYRO} = V_{PYRO}/I_{PYRO}$.

Also in this case, instead of using the instantaneous value of the resistance $R_{PYRO}$, the processing circuit 111 may further process the resistance $R_{PYRO}$, e.g., by generating the signal 195 by applying a low-pass filtering to the resistance $R_{PYRO}$ or calculating the integral of the resistance $R_{PYRO}$.

Accordingly, in a step 306, the deployment circuit 100, e.g., the comparator 112, is configured to compare the processed value 195 with the reference value 196 being indicative of a minimum threshold value, e.g., for the instantaneous, filtered or integrated value of the voltage $V_{PYRO}$ or the resistance $R_{PYRO}$, indicative of a correct deployment of the pyrotechnic device 101. In various embodiments, the threshold value 196 is programmable or at least settable.

For example, the value 196 may be a voltage value $V_{DEPLOY}$ over which the pyrotechnic device is considered successfully deployed. Specifically, the voltage $V_{DEPLOY}$ represents a minimum threshold value that characterizes the voltage of a successfully deployed device, which is expected to be in the order of a supply voltage $V_{IN}$ provided by the power supply rail 121. As explained in the foregoing, the resistance of a successfully deployed pyrotechnic device is sensibly greater than the resistance of a non-deployed pyrotechnic device thus, accordingly, the voltage drop on a deployed device is expected to be greater than the voltage drop of a non-deployed device which, on the other hand, is characterized by a lower resistance. Thus, for example, if the voltage drop measured on a pyro-fuse is $V_{PYRO} = 11.5$ V and the minimum threshold value $V_{DEPLOY}$ is set at 6 V, namely half of a biasing voltage $V_{IN} = 12$ V, it can be assumed that such pyro-fuse is correctly deployed as $V_{PYRO} \geq V_{DEPLOY}$. Accordingly, in various embodiments, the threshold signal 196 may be selected or even determined automatically as a function of the value of the voltage $V_{IN}$. For example, the threshold 196 may be selected in a range between 50% and 95% of the voltage $V_{IN}$, preferably between 70% and 90% of the voltage $V_{IN}$. For example, for this purpose, the deployment circuit 100 may also measure, e.g., via the ADC 110, the voltage $V_{IN}$.

Alternatively, the value 196 may be a resistance value $R_{DEPLOY}$ over which the pyrotechnic device is considered successfully deployed. Specifically, the resistance $R_{DEPLOY}$ represents a minimum threshold value that characterizes the resistance of a successfully deployed device, which is expected to be substantially greater than the resistance of a non-deployed pyrotechnic device. Thus, for instance, if the resistance of a pyro-fuse $R_{PYRO}$ determined by a measurement is equal to 155 Ohm and the minimum resistance characteristic of a successful deployment declared by the pyro-fuse manufacturer $R_{DEPLOY}$ is equal to 100 Ohm, it can be assumed that such pyro-fuse is correctly deployed as $R_{PYRO} \geq R_{DEPLOY}$.

Accordingly, in response to determining that the signal 195 exceeds (or at least is equal to) the threshold (output "Y" of the verification step 306), the deployment circuit 100 may detect at a step 307 a correct deployment of the pyrotechnic device 101 and assert a fire good signal 190a, e.g., corresponding to the output signal of the comparator 112. Generally, once having detected a correct deployment, the deployment cycle may be terminated immediately by proceeding to a stop step 310, where the driving circuit is deactivated, or the deployment circuit 100 may in any case wait that the timer circuit 115 reaches the respective time threshold.

On the contrary, in response to determining that the signal 195 does not exceed the threshold (output "N" of the verification step 306), the deployment circuit 100 proceeds to a step 308. In step 308 the deployment circuit 100, e.g., the control circuit 114, verifies whether a time-out condition is met i.e., if the time t tracked by the timer circuit 115 is greater than or equal to a time limit $t_{TIMEOUT}$.

In various embodiments, the time limit $t_{TIMEOUT}$ may be constant or settable, e.g., programmable. In various embodiments, the control circuit may also be configured to adapt a predetermined time limit $t_{TIMEOUT}$ based on a measurement of the value or evolution of the current $I_{PYRO}$.

In response to determining that the maximum time $t_{TIMEOUT}$ has not been reached (output "N" of the verification step 308), the deployment circuit 100 returns to the step 304, thus performing a further measurement of the voltage $V_{PYRO}$, and then proceeds with the execution of the following steps, as described in the foregoing.

Conversely, in response to determining that the maximum time $t_{TIMEOUT}$ has been reached (output "Y" of the verification step 308), the deployment circuit 100 may verify in an optional step 309 whether a further deployment cycle should be started. For example, the step 309 may be useful in order to execute up to a given maximum number of deployment cycle.

Accordingly, in the embodiment considered, when a deployment is detected at the step 307 before the time-out condition is reached, the deploy is considered successful. In this case, a possible backup deployment circuit may be inhibited from firing, e.g., by asserting the fire inhibit signal of the backup deployment circuit. Conversely, when the time-out condition is reached, another deployment cycle may be started with the same deployment circuit or the backup deployment circuit.

For example, in various embodiments, the deployment circuit 100, e.g., the control circuit 114, is configured to determine whether the ongoing deployment attempt is a first deployment attempt.

In response to determining that the ongoing deployment attempt is the first (output "Y" of the verification step 309), the deployment circuit 100 returns to the step 302, thus performing a second deployment attempt and the subsequent steps, following the order illustrated in the foregoing. For example, in step 302 the timer circuit 115 is restarted, and then the following steps are performed according to the aforementioned description. In various embodiments, instead of directly returning to the step 302, the deployment circuit 100 may first disable the driving circuit for a given time period.

On the contrary, in response to determining that the ongoing deployment attempt is not the first (output "N" of the verification step 309), the deployment circuit 100 stops further deployment attempts and the method terminates at the stop step 310 without asserting the fire good signal 190a, thus indicating that the deployment of the pyrotechnic device has failed.

Accordingly, in the embodiments considered, the step 309 enables the pyrotechnic device deployment circuit 100 to perform, in case a first deployment attempt fails, one or more further deployment attempt without the need of intervention from an external circuit, such as a microcontroller unit, thus providing a quicker and more robust solution.

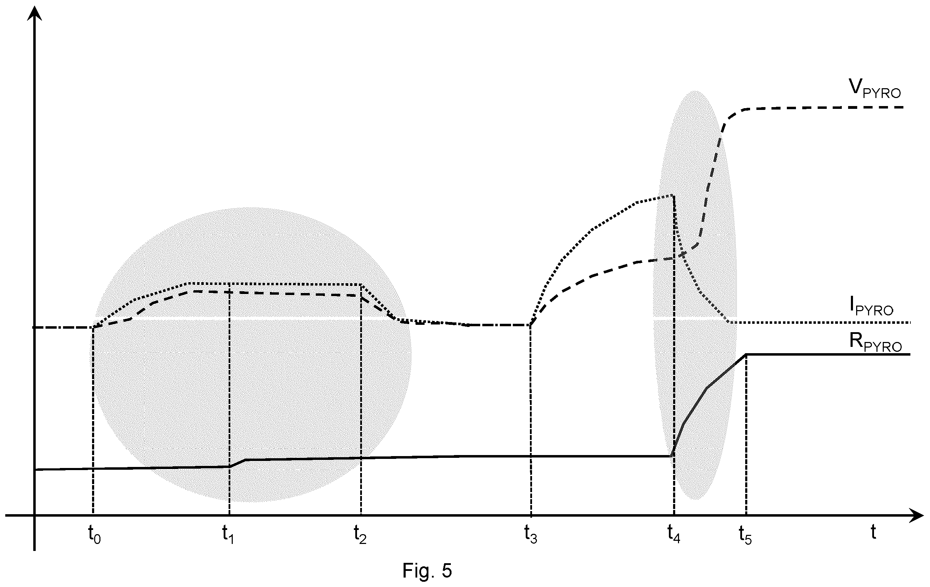

For example, Figure 5 shows a plot of the evolution in time of the current $I_{PYRO}$, the voltage $V_{PYRO}$ and the resistance $R_{PYRO}$ of a pyrotechnic device 101 wherein two deployment cycles are executed.

Specifically, at a first time instant $t_0$, a deployment operation is started. Accordingly, the pyrotechnic device 101 is biased by the deployment circuit 100, and consequently the deployment current $I_{PYRO}$ and the deployment voltage $V_{PYRO}$ start to increase, while the resistance $R_{PYRO}$ remains constant at its initial value, characteristic of a non-deployed pyrotechnic device. Similar to the example shown in Figure 4, during this time period the chemical reaction causing the firing of the pyrotechnic device is not triggered yet as the resistance $R_{PYRO}$ is keeping a (substantially) constant value, indicating that there are no changes in the structure and composition of the pyrotechnic device initiator while the deployment current $I_{PYRO}$ flows through it.

Accordingly, differently from the example shown in Figure 4, in this deployment attempt the pyrotechnic device initiator fails. In particular, the chemical reaction enabling the firing of the initiator may fail to trigger due to, for example, a not sufficient triggering temperature or a contaminated reagent. Accordingly, at the instant $t_2$ is reached the timeout condition.

At a time instant $t_2$, the pyrotechnic device deployment circuit 100 detects thus that the ongoing deployment attempt has failed and, consequently, interrupts the biasing of the pyrotechnic device. Accordingly, the voltage $V_{PYRO}$ and the current $I_{PYRO}$ decrease to zero. Then, the deployment circuit 100 schedules a second deployment attempt of the same pyrotechnic device.

After waiting a predetermined settling time, at a time instant $t_3$ the second deployment attempt is started and, consequently, the pyrotechnic device 101 is newly biased.

At a time instant $t_4$, the pyrotechnic device 101 fires causing a sudden increase of the resistance $R_{PYRO}$ and, contemporarily, a decrease of the current $I_{PYRO}$. At this time instant, the chemical reaction enabling the firing of the pyrotechnic device initiator is successfully triggered, as indicated by the substantial increase of resistance $R_{PYRO}$.

Finally, at a time instant $t_5$, the firing of the pyrotechnic device 101 is completed. Consequently, the deployment current $I_{PYRO}$ stops to decrease and the resistance $R_{PYRO}$ settles to a higher value, typical of a successfully deployed pyrotechnic device. Accordingly, the voltage $V_{PYRO}$ increases to a higher value being closer to the supply voltage. Subsequently, the pyrotechnic device deployment circuit 100 detects a successful deployment of the pyrotechnic device and outputs an asserted fire good signal 190a.

In order to provide a deeper understanding of configurations employing more than one deployment circuit 100, a system 200 comprising two daisy-chained deployment circuits 100 is illustrated in Figure 6.

Specifically, the system 200 comprises a battery pack 197, a load 198, a deployment control circuit 199, and two deployment circuits 100a and 100b respectively coupled to pyrotechnic devices 101. This system may represent, for instance, a scenario in which there is a battery pack powering one or more electric traction motors, e.g., provided in a battery electric vehicle (BEV).

When the system 200 is operating correctly, a load current $I_{LOAD}$ is drawn from the power source 197 and is absorbed by the load 198, while a voltage $V_{LOAD}$ is applied on said load 198. Moreover, the deployment control circuit 199 is, in general, configured to monitor that the load 198 is working properly and, in case of anomaly, assert a request to fire signal 191 in order to detach the battery pack 197 from the load 198.

In alternative embodiments, such deployment control circuit 199 may be connected to one or more external sensors such as, for example, an accelerometer, and may assert the request to fire signal 191 according to the readings obtained from the one or more external sensors. This could represent scenarios in which the pyrotechnic device to be deployed is, for instance, an airbag or a seat belt pretensioner.

In any case, the deployment control circuit 199 may assert the request to fire signal 191 when requested. Accordingly, the asserted request to fire signal 191 is received respectively by the primary deployment circuit 100a and by the backup deployment circuit 100b.

The primary deployment circuit 100a is configured to begin the deployment operation immediately and according to the teachings of the present solution e.g., according to the method. Conversely, the backup deployment circuit 100b is configured to begin the deployment operation after a predetermined time period $t_{DELAY}$, unless it receives an asserted fire inhibit signal 190b originating from the primary deployment circuit 100a.

In particular, in this configuration the primary deployment circuit 100a performs the first deployment attempt and, subsequently, if this first attempt is not successful, the backup deployment circuit 100b is used for performing a second deployment attempt. In case the first deployment attempt, performed by the primary deployment circuit 100a, is successful, the primary deployment circuit 100a asserts a fire good signal 190a, which is subsequently received as input as a fire inhibit signal 190b by the backup deployment circuit 100b which, consequently, does not perform the second deployment attempt. On the contrary, if the backup deployment circuit 100b does not receive the fire inhibit signal 190b before the time threshold $t_{DELAY}$ is reached, the second deployment attempt is performed. Each deployment circuit 100a, 100b may be able to wait a predetermined amount of time before initiating a deployment attempt by means of the control circuit 114 and the timer circuit 115, which are provided various embodiments of the deployment circuit 100.

Thus, for example, if a deployment control circuit 199 in a system 200 detects an anomaly on the load 198, such as a short circuit, it asserts a request to fire signal 191. Accordingly, the primary deployment circuit 100a receives the request to fire 191 and starts the first deployment attempt. If the first deployment attempt is successful, the primary deployment circuit 100a asserts the fire good signal 190a, which is in turn received by the backup deployment circuit 100b as a fire inhibit signal 190b. Accordingly, the backup deployment circuit 100b does not initiate the second deployment attempt, as the confirmation of the first successful deployment is received.

Conversely, if the first deployment attempt is not successful, the primary deployment driver 100a does not assert the fire good signal 190a. Accordingly, the backup deployment circuit 100b waits the predetermined amount of time $t_{DELAY}$ and subsequently starts the second deployment attempt. Finally, if the second deployment attempt is successful the backup deployment circuit 100b outputs an asserted fire good signal 190a to confirm the successful deployment of the pyrotechnic device.

It is evident that such a system 200 has the advantage of being able to schedule a second deployment attempt, in case a first attempt fails, without the need for an intervention of an external controller such as, for example, the deployment control circuit 199. Accordingly, by employing a system according to the solution here described, it is possible to reduce the delays that may occur during a deployment attempt of a pyrotechnic device, thus obtaining a system with a prompter response.

Accordingly, the embodiments disclosed herein relate to a new solution to drive a pyrotechnic device. The described solution performs the deployment of a given pyrotechnic device while, contemporarily, monitors the relevant figures of merit i.e., current, voltage, and resistance in order to determine whether the deployment is successful or not. Furthermore, if the deployment is not successful, the described solution can schedule a second deployment attempt of the same pyrotechnic device or, alternatively, can perform the deployment of a second pyrotechnic device as soon as the failure of the first deployment attempt if acknowledged, without the need of waiting the response of an external control circuit.

Of course, without prejudice to the principle of the invention, the details of construction and the embodiments may vary widely with respect to what has been described and illustrated herein purely by way of example, without thereby departing from the scope of the present invention, as defined by the ensuing claims.

**Claims**

1. A deployment circuit (100) for a pyrotechnic device (101), comprising:

   - a first terminal (122a) and a second terminal (122b) configured to be connected to said pyrotechnic device (101);

- a driver circuit (103, 104; 102, 104) configured to energize said pyrotechnic device (101) by selectively applying a voltage ($V_{PYRO}$) or current ($I_{PYRO}$) to said first terminal (122a) and second terminal (122b) as a function of at least one control signal (192a, 192b; 192b, 193);
- a monitoring circuit (110, 111, 112, 113) configured to:

    - measure (110, 304) a voltage ($V_{PYRO}$) across said first terminal (122a) and second terminal (122b),

    - process (111, 305) said measured voltage (194),

    - determine (112, 306) whether said processed voltage (195) is greater than a threshold (196), and

    - in response to determining that said processed voltage (195) is greater than said threshold (196), assert a comparison signal (190a); and

- a control circuit (114, 115) configured to:

    - receive a fire request signal (191) and said comparison signal (190a),

    - in response to said fire request signal (191), generate said at least one control signal (192a, 192b; 192b, 193) in order to energize said pyrotechnic device (101) via said driver circuit (103, 104; 102, 104),

    - determine whether said comparison signal (190a) is asserted or de-asserted,

    - in response to determining that said comparison signal (190a) is de-asserted, energize again said pyrotechnic device (101);

**characterized in that** said processing (111, 305) said measured voltage (194) comprises:

    - generating said processed voltage by calculating the integral of said measured voltage (194), or

    - generating said processed voltage by calculating the integral of the square of said measured voltage (194).

2. The deployment circuit (100) according to Claim 1, wherein said driver circuit (103, 104; 102, 104) comprises:

    - at least one electronic switch (192a, 192b; 192b) configured to selectively connect said first terminal (122a) and second terminal (122b) to a supply voltage ($V_{IN}$) as a function of said at least one control signal (192a, 192b).

3. The deployment circuit (100) according to Claim 2, wherein said driver circuit (103, 104; 102, 104) comprises:

    - a current limiter (102) configured to limit the current ($I_{PYRO}$) provided to said first terminal (122a) and second terminal (122b) to a maximum value.

4. The deployment circuit (100) according to Claim 3, wherein said maximum value is settable via said at least one control signal (192a, 192b).

5. The deployment circuit (100) according to any of the previous claims, wherein said control circuit (114) is configured to:

    - in response to said fire request signal (191), start a timer (115),

    - determine whether said timer reaches a time threshold ($t_{TIMEOUT}$), and

    - in response to determining that said timer reaches said time threshold ($t_{TIMEOUT}$), stop the energization of said pyrotechnic device (101) via said driver circuit (103, 104; 102, 104).

6. The deployment circuit (100) according to Claim 5, wherein said control circuit (114) is configured to determine whether said comparison signal (190a) is asserted, in response to determining that said timer reaches said time threshold.

7. The deployment circuit (100) according to Claim 4, wherein said control circuit (114, 115) is configured to:

    - in response to said fire request signal (191), set said maximum value of said current limiter (102) to a first value,

    - in response to determining that said timer reaches said time threshold, set said maximum value of said current limiter (102) to a second value, wherein said second value is smaller than said first value, and

    - then determine whether said comparison signal (190a) is asserted.

8. The deployment circuit according to any of the previous claims,

    wherein said energizing again said pyrotechnic device (101) comprises generating again said at least one control signal (192a, 192b; 192b, 193) in order to energize said pyrotechnic device (101) via said driver circuit (103, 104; 102, 104); or

    wherein said deployment circuit comprises a further driver circuit (103, 104; 102, 104) configured to energize said pyrotechnic device (101) by selectively applying a voltage ($V_{PYRO}$) or current ($I_{PYRO}$) to said first terminal (122a) and second terminal (122b) as a function of at least one further control signal (192a, 192b; 192b, 193), and wherein said energizing again said pyrotechnic device (101) comprises generating said at least one further control signal (192a, 192b; 192b, 193) in order to energize said pyrotechnic device (101) via said further driver circuit (103, 104; 102, 104).

9. An integrated circuit comprising a deployment circuit (100) according to any of the previous claims.

10. A vehicle comprising a deployment circuit (100) according to any of the previous claims 1 to 8.

11. A method of operating a deployment circuit (100) according to any of the previous claims 1 to 8, comprising providing a fire request signal (191) to said deployment circuit, whereby:

- said monitoring circuit (110, 111, 112, 113):

- measures (110, 304) the voltage ($V_{PYRO}$) across said first terminal (122a) and second terminal (122b),
- processes (111, 305) said measured voltage (194), wherein said processing (111, 305) said measured voltage (194) comprises:

- generating said processed voltage by calculating the integral of said measured voltage (194), or
- generating said processed voltage by calculating the integral of the square of said measured voltage (194),

- determines (112, 306) whether said processed voltage (195) is greater that a threshold (196), and
- in response to determining that said processed voltage (195) is greater than said threshold (196), asserts a comparison signal (190a); and

- said control circuit (114, 115):

- receives said fire request signal (191) and said comparison signal (190a),
- in response to said fire request signal (191), generates said at least one control signal (192a, 192b; 192b, 193) in order to energize said pyrotechnic device (101) via said driver circuit (103, 104; 102, 104),
- determines whether said comparison signal (190a) is asserted or de-asserted,

- in response to determining that said comparison signal (190a) is de-asserted, energizes again said pyrotechnic device (101).

**Patentansprüche**

1. Auslöseschaltung (100) für eine pyrotechnische Vorrichtung (101), umfassend:

- einen ersten Anschluss (122a) und einen zweiten Anschluss (122b), die so eingerichtet sind, dass sie mit der pyrotechnischen Vorrichtung (101) verbunden werden können;
- eine Treiberschaltung (103, 104; 102, 104), die so eingerichtet ist, dass sie die pyrotechnische Vorrichtung (101) durch selektives Anlegen einer Spannung ($V_{PYRO}$) oder eines Stroms ($I_{PYRO}$) an den ersten Anschluss (122a) und den zweiten Anschluss (122b) in Abhängigkeit von mindestens einem Steuersignal (192a, 192b; 192b, 193) bestromt;
- eine Überwachungsschaltung (110, 111, 112, 113), die für Folgendes eingerichtet ist:

- Messen (110, 304) einer Spannung ($V_{PYRO}$) über den ersten Anschluss (122a) und den zweiten Anschluss (122b),
- Verarbeiten (111, 305) der gemessenen Spannung (194),
- Bestimmen (112, 306), ob die verarbeitete Spannung (195) größer als ein Schwellenwert (196) ist, und
- als Reaktion auf das Bestimmen, dass die verarbeitete Spannung (195) größer als der Schwellenwert (196) ist, Aktivieren eines Vergleichssignals (190a); und
- eine Steuerschaltung (114, 115), die für Folgendes eingerichtet ist:

- Empfangen eines Zündungsanforderungssignals (191) und des Vergleichssignals (190a),
- als Reaktion auf das Zündungsanforderungssignal (191), Erzeugen des mindestens einen Steuersignals (192a, 192b; 192b, 193), um die pyrotechnische Vorrichtung (101) über die Treiberschaltung (103, 104; 102, 104) zu bestromen,
- Bestimmen, ob das Vergleichssignal (190a) aktiviert oder deaktiviert ist,
- als Reaktion auf das Bestimmen, dass das Vergleichssignal (190a) deaktiviert ist, erneutes Bestromen der pyrotechnischen Vorrichtung (101);

**dadurch gekennzeichnet, dass** das Verarbeiten (111, 305) der gemessenen Spannung (194) Folgendes umfasst:

- Erzeugen der verarbeiteten Spannung durch Berechnen des Integrals der gemessenen Spannung (194), oder
- Erzeugen der verarbeiteten Spannung durch Berechnen des Integrals des Quadrats der gemessenen Spannung (194).

2. Auslöseschaltung (100) nach Anspruch 1, wobei die Treiberschaltung (103, 104; 102, 104) umfasst:

- mindestens einen elektronischen Schalter (192a, 192b; 192b), der so eingerichtet ist, dass er den ersten Anschluss (122a) und den zweiten Anschluss (122b) selektiv in Abhängigkeit von dem mindestens einen Steuersignal (192a, 192b) mit einer Versorgungsspannung ($V_{IN}$) verbindet.

3. Auslöseschaltung (100) nach Anspruch 2, wobei die Treiberschaltung (103, 104; 102, 104) umfasst:

- einen Strombegrenzer (102), der so eingerichtet ist, dass er den an den ersten Anschluss (122a) und den zweiten Anschluss (122b) bereitgestellten Strom ($I_{PYRO}$) auf einen Maximalwert begrenzt.

4. Auslöseschaltung (100) nach Anspruch 3, wobei der Maximalwert über das mindestens eine Steuersignal (192a, 192b) einstellbar ist.

5. Auslöseschaltung (100) nach einem der vorhergehenden Ansprüche, wobei die Steuerschaltung (114) für Folgendes eingerichtet ist:

- als Reaktion auf das Zündungsanforderungssignal (191), Starten eines Timers (115),
- Bestimmen, ob der Timer einen Zeitschwellenwert ($t_{TIMEOUT}$) erreicht, und
- als Reaktion auf das Bestimmen, dass der Timer den Zeitschwellenwert ($t_{TIMEOUT}$) erreicht, Stoppen des Bestromens der pyrotechnischen Vorrichtung (101) über die Treiberschaltung (103, 104; 102, 104).

6. Auslöseschaltung (100) nach Anspruch 5, wobei die Steuerschaltung (114) so eingerichtet ist, dass sie bestimmt, ob das Vergleichssignal (190a) aktiviert ist, als Reaktion auf das Bestimmen, dass der Timer den Zeitschwellenwert erreicht.

7. Auslöseschaltung (100) nach Anspruch 4, wobei die Steuerschaltung (114, 115) für Folgendes eingerichtet ist:

- als Reaktion auf das Zündungsanforderungssignal (191), Einstellen des Maximalwerts des Strombegrenzers (102) auf einen ersten Wert,
- als Reaktion auf das Bestimmen, dass der Timer den Zeitschwellenwert erreicht, Einstellen des Maximalwerts des Strombegrenzers (102) auf einen zweiten Wert, wobei der zweite Wert kleiner als der erste Wert ist, und
- dann Bestimmen, ob das Vergleichssignal (190a) aktiviert ist.

8. Auslöseschaltung nach einem der vorhergehenden Ansprüche,
wobei das erneute Bestromen der pyrotechnischen Vorrichtung (101) das erneute Erzeugen des mindestens einen Steuersignals (192a, 192b; 192b, 193) umfasst, um die pyrotechnische Vorrichtung (101) über die Treiberschaltung (103, 104; 102, 104) zu bestromen; oder wobei die Auslöseschaltung eine weitere Treiberschaltung (103, 104; 102, 104) umfasst, die so eingerichtet ist, dass sie die pyrotechnische Vorrichtung (101) durch selektives Anlegen einer Spannung ($V_{PYRO}$) oder eines Stroms ($I_{PYRO}$) an den ersten Anschluss (122a) und den zweiten Anschluss (122b) in Abhängigkeit von mindestens einem weiteren Steuersignal (192a, 192b; 192b, 193) bestromt, und wobei das erneute Bestromen der pyrotechnischen Vorrichtung (101) das Erzeugen des mindestens einen weiteren Steuersignals (192a, 192b;192b, 193)) umfasst, um die pyrotechnische Vorrichtung (101) über die weitere Treiberschaltung (103, 104; 102, 104) zu bestromen.

9. Integrierte Schaltung, die eine Auslöseschaltung (100) nach einem der vorhergehenden Ansprüche umfasst.

10. Fahrzeug, das eine Auslöseschaltung (100) nach einem der vorhergehenden Ansprüche 1 bis 8 umfasst.

11. Verfahren zum Betreiben einer Auslöseschaltung (100) nach einem der vorhergehenden Ansprüche 1 bis 8, umfassend das Bereitstellen eines Zündungsanforderungssignals (191) an die Auslöseschaltung, wobei:

- die Überwachungsschaltung (110, 111, 112, 113):
- die Spannung ($V_{PYRO}$) über den ersten Anschluss (122a) und den zweiten Anschluss (122b)misst (110, 304) ,
- die gemessene Spannung (194) verarbeitet (111, 305), wobei das Verarbeiten (111, 305) der gemessenen Spannung (194) Folgendes umfasst:

- Erzeugen der verarbeiteten Spannung durch Berechnen des Integrals der gemessenen Spannung (194), oder
- Erzeugen der verarbeiteten Spannung durch Berechnen des Integrals des Quadrats der gemessenen Spannung (194),
- bestimmt (112, 306), ob die verarbeitete Spannung (195) größer als ein Schwellenwert (196) ist, und
- als Reaktion auf das Bestimmen, dass die verarbeitete Spannung (195) größer als der Schwellenwert (196) ist, ein Vergleichssignal (190a) aktiviert; und
- die Steuerschaltung (114, 115):

- ein Zündungsanforderungssignal (191) und das Vergleichssignal (190a) empfängt,
- als Reaktion auf das Zündungsanforderungssignal (191), das mindestens eine Steuersignal (192a, 192b; 192b, 193) erzeugt, um die pyrotechnische Vorrichtung (101) über die Treiberschaltung (103, 104; 102, 104) zu bestromen,
- bestimmt, ob das Vergleichssignal (190a) aktiviert oder deaktiviert ist,
- als Reaktion auf das Bestimmen, dass das Vergleichssignal (190a) deaktiviert ist, erneut die pyrotechnische Vorrichtung (101) bestromt.

## Revendications

1. Circuit de déploiement (100) d'un dispositif pyrotechnique (101), comprenant :

- une première borne (122a) et une deuxième borne (122b) configurées pour être connectées audit dispositif pyrotechnique (101) ;
- un circuit de pilotage (103, 104 ; 102, 104) configuré pour alimenter ledit dispositif pyrotechnique (101) en appliquant de manière sélective une tension ($V_{PYRO}$) ou un courant ($I_{PYRO}$) auxdites première borne (122a) et deuxième borne (122b) en fonction d'au moins un signal de commande (192a, 192b ; 192b, 193) ;
- un circuit de surveillance (110, 111, 112, 113) configuré pour :

- mesurer (110, 304) une tension ($V_{PYRO}$) entre lesdites première borne (122a) et deuxième borne (122b),
- traiter (111, 305) ladite tension mesurée (194),
- déterminer (112, 306) si ladite tension traitée (195) est supérieure à un seuil (196), et
- s'il est déterminé que ladite tension traitée (195) est supérieure audit seuil (196), valider un signal de comparaison (190a) ; et

- un circuit de commande (114, 115) configuré pour :

- recevoir un signal de demande de mise à feu (191) et ledit signal de comparaison (190a),
- en réponse audit signal de demande de mise à feu (191), générer ledit au moins un signal de commande (192a, 192b ; 192b, 193) afin d'alimenter ledit dispositif pyrotechnique (101) via ledit circuit de pilotage (103, 104 ; 102, 104),
- déterminer si ledit signal de comparaison (190a) est validé ou invalidé,
- s'il est déterminé que ledit signal de comparaison (190a) est invalidé, alimenter de nouveau ledit dispositif pyrotechnique (101) ;

**caractérisé en ce que** ledit traitement (111, 305) de ladite tension mesurée (194) comprend une opération consistant à :

- générer ladite tension traitée en calculant l'intégrale de ladite tension mesurée (194), ou
- générer ladite tension traitée en calculant l'intégrale du carré de ladite tension mesurée (194).

2. Circuit de déploiement (100) selon la revendication 1, dans lequel ledit circuit de pilotage (103, 104 ; 102, 104) comprend :

- au moins un interrupteur électronique (192a, 192b ; 192b) configuré pour connecter de manière sélective lesdites première borne (122a) et deuxième borne (122b) à une tension d'alimentation ($V_{IN}$) en fonction dudit au moins un signal de commande (192a, 192b).

3. Circuit de déploiement (100) selon la revendication 2, dans lequel ledit circuit de pilotage (103, 104 ; 102, 104) comprend :

- un limiteur de courant (102) configuré pour limiter le courant ($I_{PYRO}$) fourni auxdites première borne (122a) et deuxième borne (122b) à une valeur maximale.

4. Circuit de déploiement (100) selon la revendication 3, dans lequel ladite valeur maximale peut être réglée par l'intermédiaire dudit au moins un signal de commande (192a, 192b).

14

**5.** Circuit de déploiement (100) selon l'une quelconque des revendications précédentes, dans lequel ledit circuit de commande (114) est configuré pour :

- en réponse audit signal de demande de mise à feu (191), démarrer une minuterie (115),
- déterminer si ladite minuterie atteint un seuil de temps ($t_{TIMEOUT}$), et
- s'il est déterminé que ladite minuterie atteint ledit seuil de temps ($t_{TIMEOUT}$), arrêter l'alimentation dudit dispositif pyrotechnique (101) via ledit circuit de pilotage (103, 104 ; 102, 104).

**6.** Circuit de déploiement (100) selon la revendication 5, dans lequel ledit circuit de commande (114) est configuré pour déterminer si ledit signal de comparaison (190a) est validé, s'il est déterminé que ladite minuterie atteint ledit seuil de temps.

**7.** Circuit de déploiement (100) selon la revendication 4, dans lequel ledit circuit de commande (114, 115) est configuré pour :

- en réponse audit signal de demande de mise à feu (191), régler ladite valeur maximale dudit limiteur de courant (102) sur une première valeur,
- s'il est déterminé que ladite minuterie atteint ledit seuil de temps, régler ladite valeur maximale dudit limiteur de courant (102) sur une deuxième valeur, ladite deuxième valeur étant plus petite que ladite première valeur, et
- déterminer ensuite si ledit signal de comparaison (190a) est validé.

**8.** Circuit de déploiement (100) selon l'une quelconque des revendications précédentes,

dans lequel, lorsque l'on alimente de nouveau ledit dispositif pyrotechnique (101), on génère de nouveau ledit au moins un signal de commande (192a, 192b ; 192b, 193) afin d'alimenter ledit dispositif pyrotechnique (101) via ledit circuit de pilotage (103, 104 ; 102, 104) ; ou dans lequel ledit circuit de déploiement comprend un autre circuit de pilotage (103, 104 ; 102, 104) configuré pour alimenter ledit dispositif pyrotechnique (101) en appliquant de manière sélective une tension ($V_{PYRO}$) ou un courant ($I_{PYRO}$) auxdites première borne (122a) et deuxième borne (122b) en fonction d'au moins un autre signal de commande (192a, 192b ; 192b, 193), et dans lequel lorsque l'on alimente de nouveau ledit dispositif pyrotechnique (101), on génère ledit au moins un autre signal de commande (192a, 192b ; 192b, 193) afin d'alimenter ledit dispositif pyrotechnique (101) via ledit autre circuit de pilotage (103, 104 ; 102, 104).

**9.** Circuit intégré comprenant un circuit de déploiement (100) selon l'une quelconque des revendications précédentes.

**10.** Véhicule comprenant un circuit de déploiement (100) selon l'une quelconque des précédentes revendications 1 à 8.

**11.** Procédé de mise en œuvre d'un circuit de déploiement (100) selon l'une quelconque des précédentes revendications 1 à 8, comprenant le fait de fournir un signal de demande de mise à feu (191) audit circuit de déploiement, dans lequel :

- ledit circuit de surveillance (110, 111, 112, 113) :

- mesure (110, 304) la tension ($V_{PYRO}$) entre lesdites première borne (122a) et deuxième borne (122b),
- traite (111, 305) ladite tension mesurée (194), dans lequel ledit traitement (111, 305) de ladite tension mesurée (194) comprend une opération consistant à :

- générer ladite tension traitée en calculant l'intégrale de ladite tension mesurée (194), ou
- générer ladite tension traitée en calculant l'intégrale du carré de ladite tension mesurée (194),

- détermine (112, 306) si ladite tension traitée (195) est supérieure à un seuil (196), et
- s'il est déterminé que ladite tension traitée (195) est supérieure audit seuil (196), valide un signal de comparaison (190a) ; et

- ledit circuit de commande (114, 115) :

- reçoit ledit signal de demande de mise à feu (191) et ledit signal de comparaison (190a),
- en réponse audit signal de demande de mise à feu (191), génère ledit au moins un signal de commande (192a, 192b ; 192b, 193) afin d'alimenter ledit dispositif pyrotechnique (101) via ledit circuit de pilotage (103, 104 ; 102, 104),
- détermine si ledit signal de comparaison (190a) est validé ou invalidé,
- s'il est déterminé que ledit signal de comparaison (190a) est invalidé, alimente de nouveau ledit dispositif pyrotechnique (101).

Fig. 1

Fig. 2

Fig. 3

Fig. 4

Fig. 5

Fig. 6

EP 4 597 024 B1

## REFERENCES CITED IN THE DESCRIPTION

**Patent documents cited in the description**

- US 20180029554 A1
- US 20190302162 A1
- US 10029640 B2
- JP 1002144994 A
- US 2017349126 A1